# EUROPEAN PATENT SPECIFICATION

(11) **EP 0 277 166 B1**
(45) Date of publication and mention of the grant of the patent: **02.06.1993**
(21) Application number: 87904905.4
(22) Date of filing: 25.07.1987
(51) Int. Cl.: H01L 21/31, H01L 21/82

(54) **PROCESS FOR THE PRODUCTION OF BIPOLAR DEVICES**
VERFAHREN ZUR HERSTELLUNG EINES BIPOLAREN BAUELEMENTES
PROCEDE DE PRODUCTION DE DISPOSITIFS BIPOLAIRES

(30) Priority: 25.07.1986 GB 8618207
(43) Date of publication of application: 10.08.1988
(73) Proprietor: PLESSEY SEMICONDUCTORS LIMITED, Swindon, Wiltshire SN2 2QW (GB)
(72) Inventor: WILSON, Martin, Clive, Northampton (GB); HUNT, Peter, Charles, Towcester Northampton (GB); CHILDS, Peter, Anthony, Guildford Surrey GU1 2PB (GB)
(74) Representative: Nicholson, Ronald
(86) International application number: GB8700529
(87) International publication number: WO8801101

(56) References cited:
- US-A- 4 179 792
- IEEE TRANSACTIONS ON ELECTRON DEVICES, volume Ed-26, no. 4, April 1979, IEEE (New York, US), K. OKADA et al : "A new polysilicon process for a bipolar device - PSA technology", pages 385-389.
- PROCEEDINGS OF THE IEEE INTERNATIONAL CONFERENCE ON CIRCUITS AND COMPUTERS, ICCC 80, 1-3 October 1980, Port Chester, New York, volume 1 of 2, IEEE, (New York, US), N. TSUBOUCHI et al : "The application of high pressure oxidation process", pages 461-466.
- IEEE TRANSACTIONS ON ELECTRON DEVICES, volume ED-32, no. 2, February1985, IEEE, (New York, US), A. CUTHBERTSON et al : "Self-aligned transistors with polysilicon emitters for bipolar VLSI", pages 242-247.

## Description

This invention relates to a process for the production of bipolar devices and is particularly concerned with a process for the production of 1µm minimum feature size bipolar devices.

In designing a 1µm or submicron bipolar device, attention must be paid to those aspects of processing that will maximise performance and improve manufacture. Generally, one is sacrificed to some extent by the other and usually a compromise is reached depending on the particular application. For example, at small geometries the high speed capability of an npn bipolar transistor can be governed by the p⁺ diffusion-to-emitter edge spacing. The auto registration of the p⁺ diffusion-to-emitter edge then results in considerable improvement in device speed but has, to date, resulted in substantially more complex processing.

Furthermore, the inclusion of auto registration may completely determine the method of fabrication and give rise to additional difficulties for subsequent processing stages. For example, surface planarity may be completely lost giving rise to device metallisation and interconnect failures.

It is also important to ensure that, especially with 1µm bipolar devices, lateral oxidation beneath a nitride mask is kept to the minimum.

The present invention aims to provide a process for the production of a bipolar device in which lateral oxidation is minimised, and, preferably, a process in which the p⁺ diffusion-to-emitter edge separation is autoregistered enabling the device to be quickly and easily produced.

According to the invention, there is provided a process for the production of a bipolar device which includes the steps of depositing a layer of polysilicon on a silicon substrate containing a p-type base region, depositing a nitride layer on said polysilicon layer, applying a resist mask over said nitride layer defining a base contact region, etching away said nitride layer over said base contact region, implanting a p⁺ implant into the base region using the resist mask as an implant mask to form a base contact, forming an oxide layer at least over said base contact region, and locally oxidising the polysilicon layer over said base contact region at elevated pressure until the silicon substrate has just been penetrated.

Preferably, the nitride layer is etched by a dry etching technique. The resist layer may be removed before the deposition of the oxide layer which is preferably pyrox. The pyrox is desirably deposited to a thickness of 0.1µm to 0.2µm (1000 A to 2000 A).

Local oxidation of the polysilicon layer is desirably carried out at moderately low temperature of about 750°C to 950°C and at an elevated pressure, which may be about 1000 kPa (10 atmospheres).

After a first high pressure oxidation, the oxide layer is removed to expose the nitride layer after which a base contact cover-up mask is applied and an implant such as As⁺ carried out to form an emitter. The cover-up mask, which serves as a resist layer for the emitter implantation, is then removed and a further oxidation, which may also be at high pressure, is carried out. Finally, the nitride layer maybe removed followed by emitter drive-in and metallisation.

The invention will now be further described by way of example, with reference to the drawings, in which:-
Figure 1 is a section through a bipolar device to be produced by the process according to the invention;
Figure 2 is a section, to an enlarged scale, of the area indicated by the leter A in Figure 1; and
Figures 3 to 7 are sections, corresponding to Figure 2, showing various steps in the production of a bipolar device according to the invention.

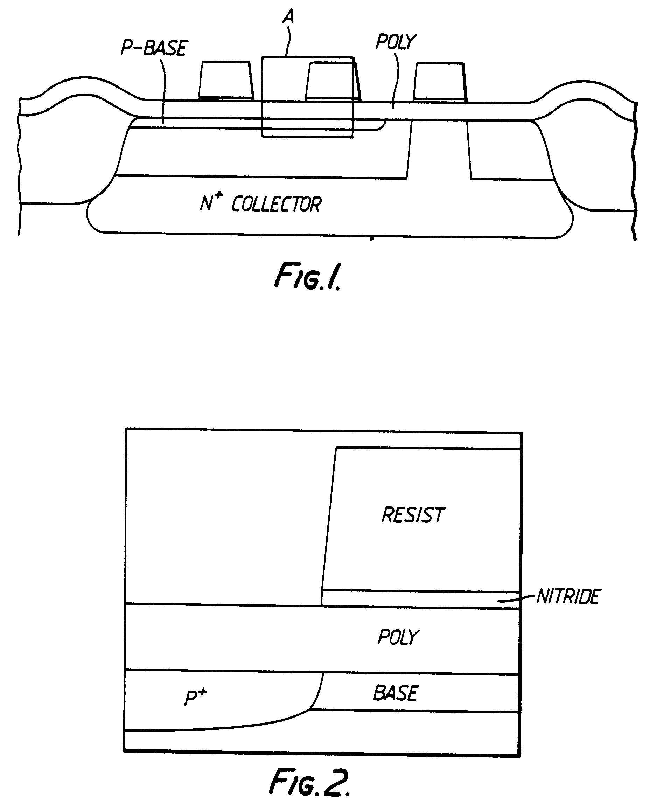

Referring to the drawings, following formation of the buried n⁺ collector, mesa and base regions, as shown in Figure 1, of the order of 0.1µm (1000 A) of polysilicon is blanket deposited. Silicon nitride of the order of 0.025µm (250 A) thick is deposited and patterned by standard dry etching techniques using a resist mask. A deep p⁺ boron implant is performed to penetrate the base region to form the base contact using the resist as the implant mask. This condition is shown in Figure 2 which shows the emitter-base region of the device since the emitter is the most critical region.

The resist is then removed and a layer of pyrox of the order of 0.2µm (2000 A) thick is deposited followed by local oxidation of the polysilicon layer. Oxidation of the polysilicon layer is performed at moderately low temperature (750°C to 950°C) and elevated pressure, 500 to 2500 kPa (5 to 25 atm). Elevated pressure is necessary to prevent excessive base redistribution.

Oxidation of silicon at elevated pressures is disclosed, for example, in US Patent No. 4,179,792, where it is utilised to make silicon integrated circuits at temperatures lower than 900°C.

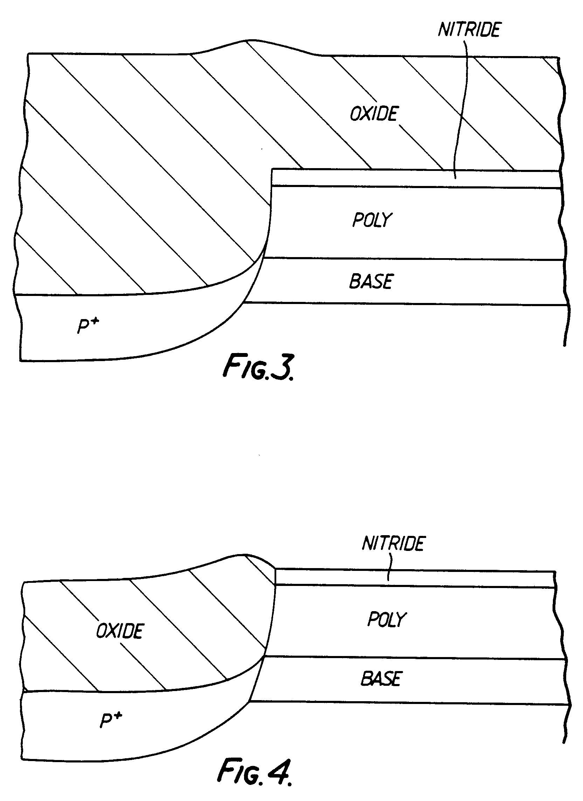

The oxidation is continued for 10 to 60 minutes until the single crystal substrate has just been penetrated and it has been found that, with the aforesaid structure and conditions, the extent of lateral oxidation is minimal with near vertical oxide side walls as shown in Figure 3 of the drawings.

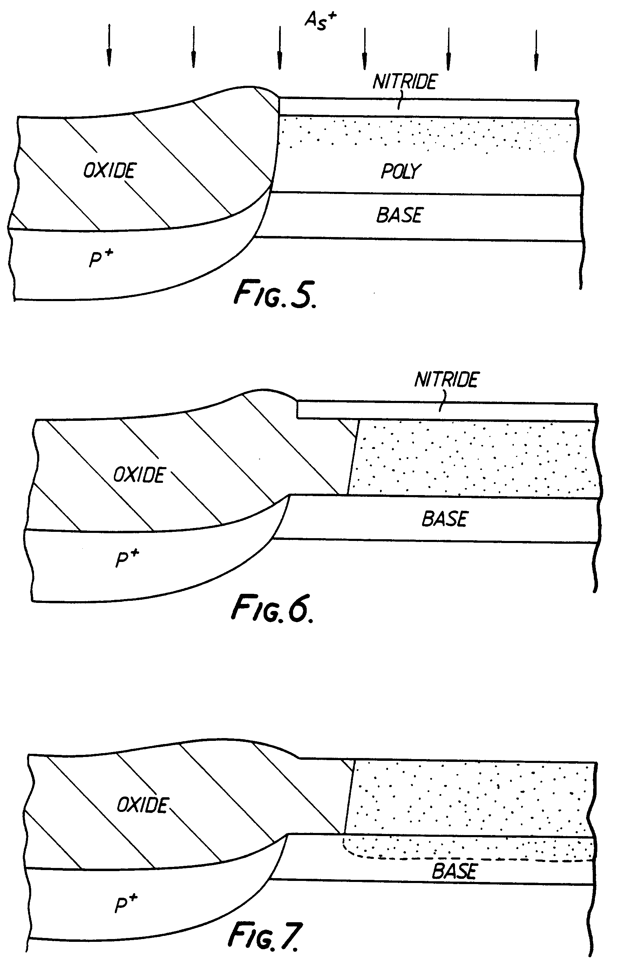

The underlying silicon nitride layer is then exposed by chemically removing the uppermost surface oxide layer to produce the structure shown in Figure 4 and a base cover-up mask (not shown) is located over the base regions after which arsenic is implanted through the silicon nitride layer into the surface region of the polysilicon layer. The alignment tolerance of the cover-up mask over the base contact is not critical and the arsenic does not penetrate the single crystal layer underlying the polysilicon layer as shown in Figure 5 of the drawings.

A further wet oxidation is then performed at a low temperature of 800°C to exploit the enhanced oxidation rate of arsenic doped polysilicon compared with lightly p doped single crystal silicon. This enhanced polysilicon oxidation rate is disclosed, for example, in IEEE Transactions on Electron Devices, Vol. ED-32, No. 3, Feb. 1985, pages 242 to 247, Cuthbertson et a., where it is utilised to form a thick masking oxide layer in polysilicon for self-alignment of p⁺ extrinsic base contact regions with the n doped emitter-contacting polysilicon.

The further oxidation may also take place at elevated pressure. Arsenic redistribution is confined to the polysilicon at this low temperature with no significant arsenic penetration into the single crystal as indicated in Figure 6. Furthermore, boron redistribution from the p⁺ and base regions is, therefore, small when compared to known processes. An oxidation rate enhancement of up to 10X has been achieved for arsenic doped polysilicon compared to boron doped single crystal. Thus, lateral oxidation extending about 0.1 m to 0.2 m (1000 - 2000 A) may be achieved with only slight vertical oxidation.

Finally, chemical removal of the silicon nitride layer is performed and the emitter-base junction formed by subsequent emitter drive-in. The emitter region is therefore separated from the p⁺ base contact by the extent of lateral oxidation as shown in Figure 7 of the drawings. The device can then be metallised using known techniques.

It has been found that in a bipolar device produced by the process according to the invention there is reduced base diffusion, minimal lateral oxidation and a near-planar surface. The process itself is simple and permits "add-on" autoregistration incorporating selective enhanced oxidation in localised areas of the polysilicon layer. The process is eminently suitable for the production of 1 m, and possibly also sub-micron, bipolar devices and achieves the aims of high speed and ease of manufacture.

## Claims

1. A process for the production of a bipolar device which includes the steps of depositing a layer of polysilicon on a silicon substrate containing a p-type base region, depositing a nitride layer on said polysilicon layer, applying a resist mask over said nitride layer defining a base contact region, etching away said nitride layer over said base contact region, implanting a p+ implant into the base region using the resist mask as an implant mask to form a base contact, forming an oxide layer at least over said base contact region, and locally oxidising the polysilicon layer over said base contact region at elevated pressure until the silicon substrate has just been penetrated.

2. A process according to Claim 1, wherein the nitride layer is etched by a dry etching technique.

3. A process according to Claim 1, wherein the p⁺ implant is boron.

4. A process according to any preceding claim wherein, after p⁺ implantation the resist layer is removed prior to deposition of the oxide layer.

5. A process according to any preceding claim, wherein the oxide layer is pyrox.

6. A process according to any preceding claim, wherein the oxide layer is deposited to a thickness of the order of 0.2µm (2000 A).

7. A process according to any preceding claim, wherein the local oxidation of the polysilicon layer is carried out at a temperature not exceeding about 950°C.

8. A process according to any preceding claim wherein the local oxidation is carried out for between 10 to 60 minutes.

9. A process according to any preceding claim, wherein the nitride layer consists of silicon nitride deposited to a thickness of the order of 0.025µm (250A).

10. A process according to any preceding claim, wherein when the oxide layer is removed, after oxidation, to expose the nitride layer a base contact cover-up mask is applied and implantation is carried out to form an emitter in the polysilicon layer over the base region.

11. A process according to Claim 10, wherein arsenic is implanted to form the emitter.

12. A process according to Claim 10 or Claim 11, wherein, after emitter implantation, further oxidation is carried out.

13. A process according to Claim 12 wherein the further oxidation is carried out at approximately 800°C.

14. A process according to Claim 12 or 13, wherein said further oxidation is also carried out at elevated pressure.

15. A process according to any one of Claims 12 to 14, wherein, after said further oxidation, the nitride layer is removed and an emitter-base junction formed by subsequent emitter drive-in.

16. A process according to Claim 15, wherein the nitride layer is chemically removed.

17. A process according to Claim 15 or Claim 16, wherein, after formation of the emitter-base junction, the device is metallised.

## Patentansprüche

1. Verfahren zur Herstellung eines bipolaren Bauelementes, welches Verfahren die Schritte enthält: Aufbringen einer Schicht aus Polysilicium auf einem Siliciumsubstrat, das eine p-Basiszone enthält, Aufbringen einer Nitridschicht auf der Polysiliciumschicht, Auftragen einer Resistmaske über der Nitridschicht zum Definieren einer Basiskontaktzone, Wegätzen der Nitridschicht über der Basiskontaktzone, Implantieren eines p⁺-Implantats in der Basiszone unter Verwendung der Resistmaske als eine Implantatmaske zur Bildung eines Basiskontaktes, Bilden einer Oxidschicht wenigstens über der Basiskontaktzone und lokales Oxidieren der Polysiliciumschicht über der Basiskontaktzone bei einem erhöhten Druck, bis das Siliciumsubstrat gerade durchdrungen ist.

2. Verfahren nach Anspruch 1, bei dem die Nitridschicht durch eine Trockenätztechnik geätzt wird.

3. Verfahren nach Anspruch 1, bei dem das p⁺-Implantat Bor ist.

4. Verfahren nach irgendeinem vorangegangenen Anspruch, bei dem nach der p⁺-Implantation die Resistschicht vor dem Aufbringen der Oxidschicht entfernt wird.

5. Verfahren nach irgendeinem vorangegangenen Anspruch, bei dem die Oxidschicht Pyrox ist.

6. Verfahren nach irgendeinem vorangegangenen Anspruch, bei dem die Oxidschicht aufgebracht wird bis zu einer Dicke in der Größenordnung von 0,2µm (2000 Å).

7. Verfahren nach irgendeinem vorangegangenen Anspruch, bei dem das lokale Oxidieren der Polysiliciumschicht ausgeführt wird bei einer Temperatur, die etwa 950 °C nicht überschreitet.

8. Verfahren nach irgendeinem vorangegangenen Anspruch, bei dem das lokale Oxidieren ausgeführt wird für eine Zeit zwischen 10 bis 60 min.

9. Verfahren nach irgendeinem vorangegangenen Anspruch, bei dem die Nitridschicht aus Siliciumnitrid besteht, das bis zu einer Dicke in der Größenordnung von 0,025µm (250 Å ) aufgetragen wird.

10. Verfahren nach irgendeinem vorangegangenen Anspruch, bei den, wenn nach der Oxidation die Oxidschicht entfernt ist, um die Nitridschicht freizulegen, eine Basiskontaktzudeckmaske angewendet wird und eine Implantation ausgeführt wird, um in der Polysiliciumschicht über der Basiszone einen Emitter zu bilden.

11. Verfahren nach Anspruch 10, bei dem Arsen implantiert wird, um den Emitter zu bilden.

12. Verfahren nach Anspruch 10 oder Anspruch 11, bei den nach der Emitterimplantation eine weitere Oxidation ausgeführt wird.

13. Verfahren nach Anspruch 12, bei dem die weitere Oxidation bei etwa 800 °C ausgeführt wird.

14. Verfahren nach Anspruch 12 oder 13, bei dem die weitere Oxidation auch bei einem erhöhten Druck ausgeführt wird.

15. Verfahren nach irgendeinem der Ansprüche 12 bis 14, bei dem nach der weiteren Oxidation die Nitridschicht entfernt wird und durch anschließenden Emittereintrieb ein Emitter-Basis-Übergang ausgebildet wird.

16. Verfahren nach Anspruch 15, bei dem die Nitridschicht chemisch entfernt wird.

17. Verfahren nach Anspruch 15 oder Anspruch 16, bei dem nach der Ausbildung des Emitter-Basis-Übergangs das Bauelement metallisiert wird.

## Revendications

1. Procédé de fabrication d'un dispositif bipolaire, comprenant les étapes suivantes : le dépôt d'une couche de silicium polycristallin sur un substrat de silicium contenant une région de base de type p, le dépôt d'une couche de nitrure sur la couche de silicium polycristallin, l'application d'un masque d'une matière de réserve sur la couche de nitrure pour la délimitation d'une région de contact de base, l'attaque de la couche de nitrure placée au-dessus de la région de contact de base, l'implantation d'une matière d'implantation p⁺ dans la région de base à l'aide du masque de matière de réserve utilisé comme masque d'implantation pour la formation d'un contact de base, la formation d'une couche d'oxyde au moins au-dessus de la région de contact de base, et l'oxydation locale de la couche de silicium polycristallin sur la région de contact de base, à une pression élevée, jusqu'à ce que le substrat de silicium soit tout juste atteint.

2. Procédé selon la revendication 1, dans lequel la couche de nitrure est attaquée par une technique d'attaque à sec.

3. Procédé selon la revendication 1, dans lequel la matière d'implantation p⁺ est le bore.

4. Procédé selon l'une quelconque des revendications précédentes, dans lequel après l'implantation p⁺, la couche de la matière de réserve est retirée avant le dépôt de la couche d'oxyde.

5. Procédé selon l'une quelconque des revendications précédentes, dans lequel la couche d'oxyde est de l'oxyde pyrolitique.

6. Procédé selon l'une quelconque des revendications précédentes, dans lequel la couche d'oxyde est déposée avec une épaisseur de l'ordre de 0,2 µm (2000 Å).

7. Procédé selon l'une quelconque des revendications précédentes, dans lequel l'oxydation locale de la couche de silicium polycristallin est exécutée à une température qui ne dépasse pas 950°C environ.

8. Procédé selon l'une quelconque des revendications précédentes, dans lequel l'oxydation locale est réalisée pendant 10 à 60 min.

9. Procédé selon l'une quelconque des revendications précédentes, dans lequel la couche de nitrure est formée de nitrure de silicium déposé avec une épaisseur de l'ordre de 0,025 µm (250 Å).

10. Procédé selon l'une quelconque des revendications précédentes, dans lequel, lorsque la couche d'oxyde est retirée, après oxydation, pour l'exposition de la couche de nitrure, un masque de recouvrement de contact de base est appliqué et l'implantation est réalisée pour la formation d'un émetteur dans la couche de silicium polycristallin au-dessus de la région de base.

11. Procédé selon la revendication 10, dans lequel l'arsenic est implanté pour la formation de l'émetteur.

12. Procédé selon la revendication 10 ou 11, dans lequel une oxydation supplémentaire est réalisée après l'implantation d'émetteur.

13. Procédé selon la revendication 12, dans lequel l'oxydation supplémentaire est réalisée à 800°C environ.

14. Procédé selon la revendication 12 ou 13, dans lequel l'oxydation supplémentaire est aussi réalisée à une pression élevée.

15. Procédé selon l'une quelconque des revendications 12 à 14, dans lequel, après l'oxydation supplémentaire, la couche de nitrure est retirée et une jonction émetteur-base est formée par pénétration ultérieure dans l'émetteur.

16. Procédé selon la revendication 15, dans lequel la couche de nitrure est retirée chimiquement.

17. Procédé selon la revendication 15 ou 16, dans lequel le dispositif subit une métallisation après la formation de la jonction émetteur-base.
